Europäisches Patentamt

European Patent Office

Office européen des brevets

(11) Publication number: 0 382 988
A1

## (12) EUROPEAN PATENT APPLICATION

(21) Application number: 89400392.0

(22) Date of filing: 13.02.89

(51) Int. Cl.5: C23C 16/44

(43) Date of publication of application:
22.08.90 Bulletin 90/34

(84) Designated Contracting States:
FR

(71) Applicant: L'AIR LIQUIDE, SOCIETE ANONYME POUR L'ETUDE ET L'EXPLOITATION DES PROCEDES GEORGES CLAUDE
75, Quai d'Orsay
F-75321 Paris Cédex 07(FR)

(72) Inventor: Hirase, Ikuo
5-9-9 Tokodai Toyosato-machi
Tsucuba-Gun 300-26(JP)

(74) Representative: Vesin, Jacques et al
L'AIR LIQUIDE, SOCIETE ANONYME POUR L'ETUDE ET L'EXPLOITATION DES PROCEDES GEORGES CLAUDE 75, quai d'Orsay
F-75321 Paris Cédex 07(FR)

(54) CVD apparatus.

(57) A CVD apparatus comprising a reaction container (1) provided with a raw material gas entrance (3) and an exhaust opening (5), and a temperature control medium passage (2) formed in the wall of the reaction container (1) wherein a raw material gas is subjected to CVD reaction, using a heating source (13) in the reaction container, to deposit a thin CVD film on the surface of a substrate (15) placed on a support member (11) in the reaction container, characterized in that means (23, 24) for supplying a heating medium to the temperature control medium passage (2) are provided to circulate the heating medium through the temperature control medium passage (2) when degasing is conducted.

FIG. 2

## CVD apparatus

The present invention relates to a CVD apparatus and more particularly, it relates to an improvement of the means for degasing the reaction container in the CVD apparatus.

CVD (chemical vapor deposition) is a method of forming various kinds of thin film on the surface of a substrate. The manufacture of semiconductor devices such as IC, for example, includes many processes of forming thin films of polycrystalline silicon and $SiO_2$ on the surface of a silicon wafer according to the CVD.

Various apparatuses have been well known to carry out the CVD. One of them is of the hot wall type intended to supply energy needed for deposition reaction to the reaction container by heating the container from outside. Another is of the cold wall type in which the heating source is located in the reaction container and cooling water is circulated to cool the wall of the container. The other is of the plasma CVD type intended to supply energy for the deposition reaction to the reaction container, using plasma generated in the container. The hot wall type and plasma CVD apparatuses are popularly used. When special CVD called selective CVD is to carried, however, the CVD apparatus of the cold wall type is most suitable.

The selective CVD is employed to form refractory metals such as Ti, W, Mo and Ta. The reason why it is called selective CVD is that when the CVD is carried out using $WF_6$ as its raw material gas, for example, a thin film of W is formed only on the surfaces of Si and metal but not on the surface of insulation film such as $SiO_2$. The selective CVD thus enables metal film patterns of any shape to be formed without carrying out PEP (photo-engraving process). The selective CVD is therefore expected as a micro-processing technique needed for the super LSI process. When the selective CVD is conducted using the reaction container of the hot wall type made of stainless steel, W and the like are deposited on the wall of the container. These depositions increase the amount of the raw material gas consumed and cause the thin film formed on the substrate to have defects. The CVD apparatus of the cold wall type is thus needed to prevent these depositions from being formed on the inner face of the container wall. It is therefore expected that need for the CVD apparatus of the cold wall type will increase in the future.

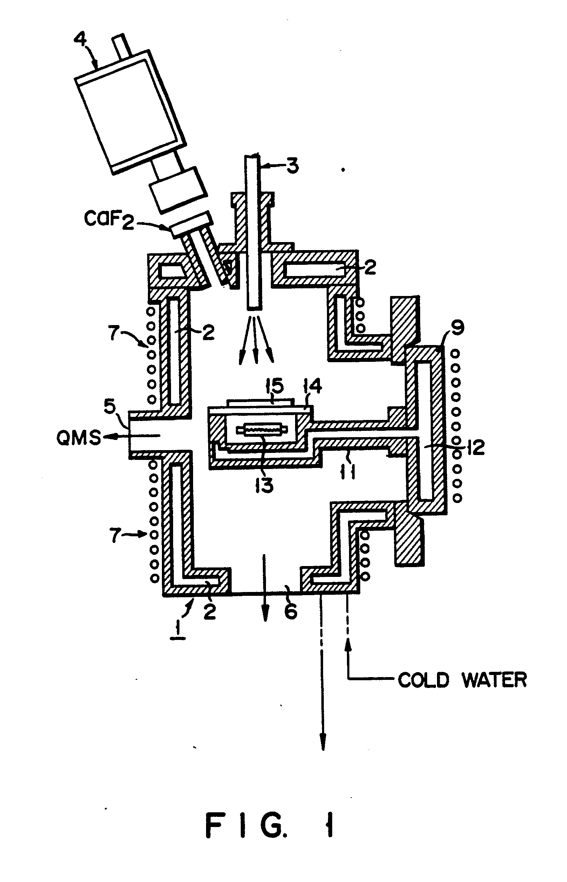

Fig. 1 is a sectional view showing the conventional CVD apparatus of the cold wall type and main portions of the apparatus are hatched. Numeral 1 represents a reaction container made of stainless steel. This reaction container has double wall structure consisting of inner and outer walls.

Cooling water passage 2 is provided between the inner and outer walls and cooling water is circulated through cooling water passage 2. Reaction container 1 is provided with raw material gas supply tube 3 and infrared thermometer 4. It is also provided with exhaust opening 5 and aspiration opening 6 for reducing the pressure in the reaction container. A vacuum pump (not shown) is connected to aspiration opening 6. Heater 7 is arranged along the outer wall of reaction container 1. The entrance of the reaction container is closed by valve 9, to which support arm 11 is connected. Infrared lamp 13 is arranged in a recess at the foremost end of support arm 11 and hot plate 14 is mounted on the recess. Cooling water passage 12 is formed in both of valve 9 and support arm 11 and cooling water is circulated through this cooling water passage 12, similarly to the case of cooling water passage 2 formed in the inner and outer walls of the reaction container. Semiconductor water 15 to be process is mounted on hot plate 14.

When the CVD apparatus is maintained with its reaction container open to atmosphere, gas components such as $H_2O$, $O_2$ and $N_2$ are adsorbed onto the inner face of the reaction container. When this CVD apparatus is used as it is, the adsorbed gas components react with the raw material gas to generate particles which degrade the quality of the thin film deposited. Therefore, the reaction container must be degassed before the CVD is carried out. When a CVD process is finished and another CVD process is to be started, the reaction container also must be degassed because the raw material gas used in the previous CVD process has been adsorbed onto the inner face of the reaction container. Further, when the use of the apparatus is finished and it is maintained with its reaction container open to atmosphere, similar degasing must be conducted for various reasons. When halide gases such as $WF_6$, $MoF_6$ and halogenated silane adhere to the inner face of the reaction container, for example, they react with water in the air to create particles and highly corrosive halogeno-acid such as HF, and the apparatus is thus corroded. When the absorbed gas is $SiH_4$, particles are still created by the reaction with $O_2$ in the air, while the corrosion is not caused. In the case of poisonous gas such as $AsH_3$, the health of operators will be remarkably damaged.

The degasing is carried out by heating the reaction container to expel those gases which adhere on the inner face of the reaction container. In the case of the conventional CVD apparatus of the cold wall type shown in Fig. 1, heater 7 is arranged along the outer wall of the reaction container. However, heating efficiency is low and a long time heating is needed to achieve sufficient degasing effect because the reaction container having the double wall structure is heated from outside its outer wall. As apparent from Fig. 1, no heater can be attached to support arm 11 in the reaction container. Therefore, gases adsorbed onto support arm 11 cannot be effectively degassed.

In the case of the CVD apparatus of the hot wall type, however, the above-mentioned problems are not caused because this type apparatus has such a structure as enables efficient heating to be carried out from outside its container.

The object of the present invention is to provide a CVD apparatus having a heating source in the reaction container as seen in those of the cold wall type and capable of achieving the degasing for a short time and with high efficiency even if efficient heating from outside the container is difficult.

This object can be attained by a CVD apparatus comprising a reaction container provided with a raw material gas entrance and an exhaust opening, and a temperature control medium passage formed in the wall of the reaction container, wherein a raw material gas is subjected to CVD reaction by heat supplied from a heating source in the reaction container to deposit a thin CVD film on the surface of a substrate mounted on a support member in the reaction container, characterized in that means for supplying a heating medium to the temperature control medium passage is provided to circulate the heating medium through the passage when the degasing is conducted.

Hot water, heating vapor, hot oil or the like is used as the heating medium. Kind and temperature of the heating medium are selected depending upon the kind of those substances which are degassed. When high heating temperature is needed, hot oil is more preferable than hot water.

The present invention can be applied to not only the CVD apparatus of the . cold wall type shown in Fig. 1 but also any type of CVD apparatuses such as the plasma CVD apparatus which need not to heat the wall of their reaction containers for causing the CVD reaction. When the present invention is applied to the CVD apparatus of the cold wall type shown in Fig. 1, cooling water passages 2 and 12 can be used as they are for heating medium. A means for switching cooling water to heating medium to be supplied to passages 2 and 12 is provided in this case. Cooling medium such as cold oil may be used instead of cooling water. When hot oil is used as the heating medium, cold oil is preferably used as the cooling medium to enable heating and cooling to be conducted with same medium. Gas such as fluorocarbon gas which is well known as the trade name "Freon" may be used as the cooling medium if needed.

According to the CVD apparatus of the present invention, the wall of the reaction container is heated by a heating medium circulating in the wall. Therefore, the inner face of the reaction container can be more rapidly heated as compared with the conventional one shown in Fig. 1 which is heated by a heater from outside the container. Desired degasing can be thus attained for a shorter time and with higher efficiency.

This invention can be more fully understood from the following detailed description when taken in conjunction with the accompanying drawings, in which:

Fig. 1 is a sectional view showing the conventional CVD apparatus of the cold wall type; and

Fig. 2 is a sectional view showing an example of the CVD apparatus of the cold wall type according to the present invention.

The present invention will be described in more detail with reference to its embodiment.

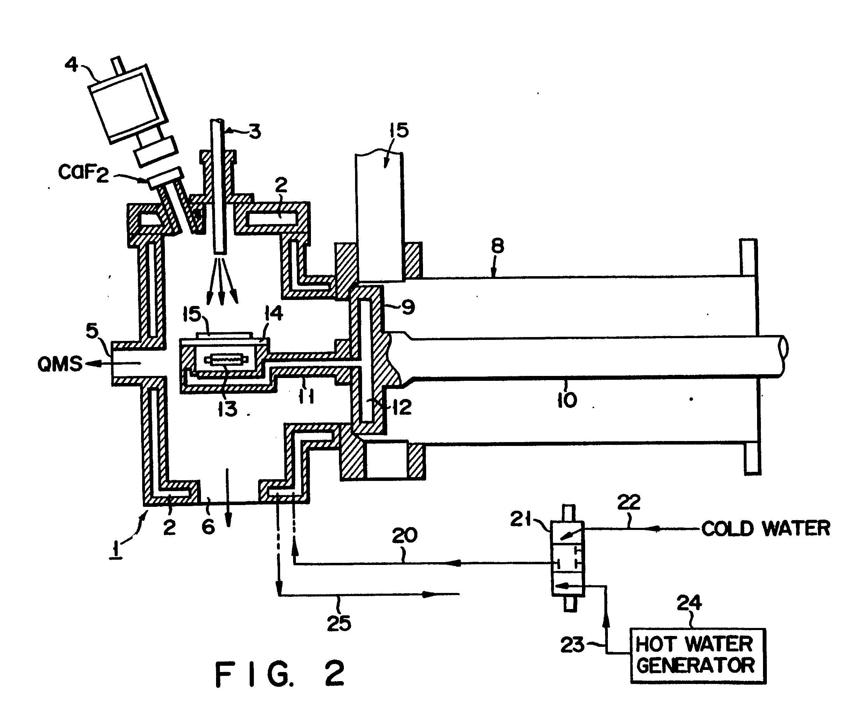

Fig. 2 is a sectional view showing an example of the CVD apparatus of the cold wall type according to the present invention, in which main portions of the apparatus are hatched. Numeral 1 represents a reaction container made of stainless steel. This reaction container has double wall structure consisting of inner and outer walls and temperature control medium passage 2 is formed between these two walls. Reaction container 1 is provided with raw material gas supply tube 3 and infrared thermometer 4. It is also provided with exhaust opening 5 and aspiration opening 6 for reducing pressure in the reaction container. A vacuum pump (not shown) is connected to aspiration opening 6.

Loading chamber 8 is attached to reaction container 1. Reaction container 1 and loading chamber 8 which are communicated with each other are shut off by valve body 9 from each other. Piston rod 10 is connected to valve body 9. Valve body 9 is moved through loading chamber 8 in lateral direction by means of the piston rod and the boundary between reaction container 1 and loading chamber 8 is thus closed or opened. Support arm 11 is attached to that side of valve body 9 which faces the reaction container. Infrared lamp 13 is arranged in a recess at the foremost end of support arm 11 and hot plate 14 is mounted on the recess. Temperature control medium passage 12 is formed in both of valve body 9 and support arm 11. Semiconductor wafer 15 to be processed is placed on hot plate 14. Semiconductor wafer 15 is loaded on hot plate 14 holding support arm 11 pulled into loading chamber 8. The border between reaction container 1 and loading chamber 8 is closed by gate valve 15 during the loading operation of wafer 15.

Temperature control medium supply line 20 is connected to temperature control medium passages 2 and 12. Line 20 can be connected to either of cold and hot water supply lines 22 and 23 by means of electromagnetic valve 21. A pneumatic operated valve or a manually operated valve can be employed instead of electromagnetic valve 21. Hot water generator 24 is connected to hot water supply line 23. When line 20 is connected to cold water line 22, cold water is supplied to passages 2 and 12. When line 20 is connected to hot water line 23, hot water is supplied to passages 2 and 12. Cold or hot water supplied is discharged through line 25.

In the case of the CVD apparatus having the above-described arrangement, cold water is flowing through passages 2 and 12, while CVD is being carried out, to cool the inner face of reaction container 1 and the surface of support arm 11. when the degasing is to be conducted, hot water is flowing through passages 2 and 12 to heat the inner face of reaction container 1 and the surface of support arm 11. when heated by the circulating hot water, the inner face of reaction container 1 is more quickly heated than in the case where reaction container 1 is heated from outside by the heater. Further, support arm 11 is also similarly heated in this CVD apparatus to effectively expel those gases adsorbed on the surface of support arm 11. When loading chamber 8 is attached to the conventional CVD apparatus shown in Fig. 1, valve body 9 cannot be heated, but it can be heated in the case of the above-described CVD apparatus which is an embodiment of the present invention. According to the CVD apparatus of the present invention, therefore, the degasing can be attained more quickly and with higher quality.

It should be noted that a similar passage for temperature control medium can be formed also in raw material gas supply tube 3 by employing a duplex pipe for tube 3, and more superior degasing effect can be obtained by heating tube 3 with circulating hot water.

An example in which the degasing of the above-mentioned CVD apparatus was carried out will be described below.

Example:

The degasing of $H_2O$ was conducted under the following conditions;
Temperature of hot water: 98° C
Circulating time of hot water: 30 minutes
The whole inner face of the reaction container was heated to 98° C, including surfaces of hot plate 14 and support arm 11. As the result, sufficient degasing effect was obtained and the total pressure in reaction container 1 was reduced to 3 ×

$10^{-7}$ Torr in the condition of maintaining a suction with a turbo-pump. In the analysis using a mass spectrometer, peaks of $H_2O$, $O_2$ and $N_2$ were detected.

For comparison, the degasing of $H_2O$ was conducted under the following conditions, using the conventional CVD apparatus of the cold wall type shown in Fig. 1;
Power of heater 7: 600 w
Temperature of heater 7: 170° C
Heating time: 60 minutes
The surfaces of hot plate 14 and support arm 11 were not heated but kept at room temperature. As the result, degasing effect was insufficient and the total pressure in reaction container was reduced only to 5 × $10^{-6}$ Torr in the condition of maintaining a suction with a turbo-pump.

As apparent from the above, the CVD apparatus of the present invention enables more excellent degasing to be attained for a time period, about 30 minutes shorter, as compared with the conventional CVD apparatus.

Further, QMS measurement was carried out at gain 9 after the above degasing process. The peak of $H_2O$ in the CVD apparatus of the present invention was lower than 1/10 of the peak of $H_2O$ in the conventional CVD apparatus shown in Fig. 1. It can be understood from this result that more extremely excellent degasing effect is attained with the CVD apparatus of the present invention.

Claims

1. A CVD apparatus comprising a reaction container (1) provided with a raw material gas entrance (3) and an exhaust opening (5), and a temperature control medium passage (2) formed in the wall of the reaction container (1) wherein a raw material gas is subjected to CVD reaction, using a heating source (13) in the reaction container, to deposit a thin CVD film on the surface of a substrate (15) placed on a support member (11) in the reaction container, characterized in that means (23, 24) for supplying a heating medium to the temperature control medium passage (2) are provided to circulate the heating medium through the temperature control medium passage (2) when degasing is conducted.

2. The CVD apparatus according to claim 1, characterized in that a temperature control medium passage (12) is also formed in the support member (11) arranged in the reaction container (1).

3. The CVD apparatus according to claim 1 or 2, characterized in that a means (22) for supplying a cooling medium to the temperature control medium passages (2, 12) is provided to supply and circulate the cooling medium through the passages (2, 12) while CVD reaction is being conducted.

4. The CVD apparatus according to claim 3, characterized in that an electromagnetic valve (21) is provided to switch the supply of the heating medium to that of the cooling medium and vice versa.

FIG. 1

FIG. 2

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| Y | PATENT ABSTRACTS OF JAPAN, vol. 10, no. 197 (E-418)[2253], 10th July 1986; & JP-A-61 40 024 (TOSHIBA MACH. CO. LTD) 26-02-1986 * Abstract * | 1,3 | C 23 C   16/44 |
| Y | IBM TECHNICAL DISCLOSURE BULLETIN, vol. 23, no. 9, February 1981, page 4133, New York, US; S. GRIVJACK et al.: "Cleaning process for a contaminated vacuum system" * Whole article * | 1,3 | |
| A | US-A-4 724 160 (ARVIDSON et al.) * Figure 1; column 4, lines 40-51 * | 1,4 | |

TECHNICAL FIELDS SEARCHED (Int. Cl.5)

C 23 C

The present search report has been drawn up for all claims

| Place of search | Date of completion of the search | Examiner |
|---|---|---|
| THE HAGUE | 13-10-1989 | PATTERSON A.M. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)